# EUROPÄISCHE PATENTSCHRIFT

(11) **EP 3 361 596 B1**
(45) Veröffentlichungstag und Bekanntmachung des Hinweises auf die Patenterteilung: **29.04.2020**
(21) Anmeldenummer: 17155124.5
(22) Anmeldetag: 08.02.2017
(51) Int. Cl.: H02J 7/00, H01H 1/00

(54) **BATTERIE MIT EINEM BATTERIEMANAGEMENTSYSTEM, DAS EINE ELEKTRONISCHE SCHALTEINRICHTUNG UMFASST**
BATTERY WITH A BATTERY MANAGEMENT SYSTEM WHICH COMPRISES AN ELECTRONIC SWITCHING CIRCUIT
BATTERIE AVEC UN SYSTÈME DE GESTION DE BATTERIE COMPRENANT UN DISPOSITIF INTERRUPTEUR

(43) Veröffentlichungstag der Anmeldung: 15.08.2018
(73) Patentinhaber: VARTA Microbattery GmbH, 73479 Ellwangen Jagst (DE)
(72) Erfinder: Kloos, Dieter, 74579 Fichtenau (DE)
(74) Vertreter: Patentanwaltskanzlei Cartagena

(56) Entgegenhaltungen:
- EP-A1- 1 498 998
- EP-A1- 2 110 934
- US-A- 5 909 103

## Beschreibung

Die Erfindung betrifft eine Batterie mit einer elektronischen Schalteinrichtung, die Bestandteil eines Batteriemanagementsystems ist.

Eine Batterie umfasst in der Regel stets mehrere Batteriezellen und ein Batteriemanagementsystem. Das Batteriemanagementsystem umfasst wiederum üblicherweise eine Überwachungseinrichtung, die das Verhalten der Batteriezellen überwacht, sowie eine Schalteinrichtung, die sicherstellt, dass ein Strom zu und/oder von den Batteriezellen nur dann fließt, wenn dies von der Überwachungseinrichtung zugelassen wird. Die Überwachungseinrichtung überwacht Parameter, die für den korrekten Betrieb und die Sicherheit relevant sind. Dazu gehört beispielsweise auch die Temperatur der Batterie.

Die Schalteinrichtung verwendet üblicherweise Halbleiterschaltelemente, insbesondere MOSFETs. Diese haben die Eigenschaft, dass sie als Schalter nur in einer Richtung arbeiten können, da sie den Stromfluss nur in einer Richtung sperren können. Da gegebenenfalls aber in beide Richtungen gesperrt werden muss, werden diese Halbleiterschaltelemente in umgekehrter Orientierung (antiseriell) hintereinander geschaltet. Damit können sowohl Ladeströme als auch Entladeströme abgeschaltet werden. Häufig werden, um eine ausreichende Stromtragfähigkeit zu gewährleisten, solche Anordnungen von hintereinander geschalteten Halbleiterschaltelementen mehrfach parallel angeordnet.

Die Anordnung der Halbleiterschaltelemente ist im Stand der Technik symmetrisch. Hierunter ist zu verstehen, dass zur Sperrung des Stromflusses in beide Richtungen jeweils die gleiche Anzahl von Halbleiterschaltelementen eingesetzt wird. Die verwendeten Halbleiterschaltelemente sind hierbei identisch, lediglich innerhalb der Schalteinrichtung unterscheiden sie sich durch die Richtung, in der sie geschaltet sind. Insbesondere weisen alle verwendeten Halbleiterschaltelemente die gleiche Spannungsfestigkeit auf. Der Kennwert Spannungsfestigkeit gibt bei elektronischen Bauteilen wie Halbleiterschaltelementen bekanntlich die Spannung an, bei dem das entsprechende Bauteil noch betrieben werden kann. Derartige symmetrische Anordnungen sind beispielsweise aus der EP 1 498 998 A1 und US 5909103 A bekannt.

Aus EP 2110934 A1 sind asymmetrische Anordnungen von Halbleiterschaltelementen für Halbleiterschalter in Kombination mit Freilaufdioden bekannt, welche in Leistungsumwandlungssystemen Verwendungfinden.

Es hat sich nun herausgestellt, dass die bekannten Schalteinrichtungen für ein Batteriemanagementsystem Nachteile im Hinblick auf Kosten und Effizienz aufweisen.

Der Erfindung lag die Aufgabe zu Grunde, eine elektronische Schalteinrichtung für ein Batteriemanagementsystem zu schaffen, welche bei verringerten Kosten eine erhöhte Effizienz aufweist.

Zur Lösung dieser Aufgabe schlägt die Erfindung eine Batterie mit einer Schalteinrichtung mit den im Anspruch 1 genannten Merkmalen vor. Weiterbildungen der Erfindung sind Gegenstand von Unteransprüchen.

Im Gegensatz zum Stand der Technik ist die elektronische Schalteinrichtung, wie sie von der Erfindung vorgeschlagen wird, nicht mehr symmetrisch, sondern die für das Schalten in Entladerichtung und für das Schalten in Laderichtung zuständigen Halbleiterschaltelemente sind an ihre jeweiligen maximal zu erwartenden Belastungen angepasst, die nach Erkenntnis der vorliegenden Erfindung ihrerseits gleichfalls nicht symmetrisch sind.

Die erfindungsgemäße Batterie umfasst stets
- einen Batteriezellenverbund und
- ein Batteriemanagementsystem.

Das Batteriemanagementsystem umfasst eine elektronische Schalteinrichtung mit den folgenden Merkmalen:
- Sie umfasst einen elektrischen Leitungszweig, in dem mindestens zwei Halbleiterschaltelemente in umgekehrter Orientierung hintereinander geschaltet sind.
- Die Halbleiterschaltelemente sind dazu ausgebildet, einen Stromfluss in dem Leitungszweig in einer Richtung sperren zu können.
- Ein Ende des Leitungszweigs ist mit einem Pol des Batteriezellenverbundes verbunden, eine anderes Ende mit einer Spannungsquelle.
- Mindestens eines der Halbleiterschaltelemente weist innerhalb des Leitungszweigs eine Orientierung auf, die es ihm erlaubt, beim Aufladen des Batteriezellenverbundes einen Ladestrom zu sperren.
- Das mindestens eine Halbleiterschaltelement zum Sperren des Ladestroms ist in einem ersten Teil des Leitungszweigs angeordnet.
- Mindestens eines der Halbleiterschaltelemente weist innerhalb des Leitungszweigs eine Orientierung auf, die es ihm erlaubt, beim Entladen des Batteriezellenverbundes einen Strom in Entladerichtung zu sperren.
- Das mindestens eine Halbleiterschaltelement zum Sperren des Stroms in Entladerichtung ist in einem zweiten Teil des Leitungszweigs angeordnet.
- Das mindestens eine Halbleiterschaltelement zum Sperren des Ladestroms ist an die größtmögliche in dem ersten Teil in Laderichtung möglicherweise auftretende Spannungsbelastung angepasst.
- Das mindestens eine Halbleiterschaltelement zum Sperren des Stroms in Entladerichtung ist an die größtmögliche in dem zweiten Teil in Entladerichtung möglicherweise auftretende Spannungsbelastung angepasst.

Die Spannungsquelle dient insbesondere zum Aufladen des Batteriezellenverbundes. Entsprechend ist die Spannungsquelle bevorzugt eine Gleichspannungsquelle.

Bei der Gleichspannungsquelle kann es sich insbesondere auch um ein Gleichspannungsnetz handeln, welches außer Ladung auch Entladung zulässt.

Die in Laderichtung in dem ersten Teil des Leitungszweigs auftretende Spannungsbelastung ergibt sich aus der Differenz einer von der Spannungsquelle gelieferten Ladespannung und der Spannung des Batteriezellenverbundes. Die Spannungsbelastung ist in der Regel maximal, wenn der Batteriezellenverbund tiefentladen ist.

Die in Entladerichtung in dem zweiten Teil des Leitungszweigs auftretende Spannungsbelastung ergibt sich im Extremfall einer Verpolung aus einer Addition der von der Spannungsquelle gelieferten Ladespannung und der Spannung des Batteriezellenverbundes. Die Spannungsbelastung ist dann maximal, wenn der Batteriezellenverbund voll geladen ist.

Hieraus folgt, dass die in Entladerichtung maximal auftretenden Spannungsbelastungen in der Regel größer sind als die in Laderichtung maximal auftretenden Spannungsbelastungen.

Bevorzugt erfolgt die Anpassung an die in Laderichtung oder Entladerichtung möglicherweise auftretende Spannungsbelastung durch Auswahl von Halbleiterschaltelementen mit geeigneter Spannungsfestigkeit.

Das mindestens eine Halbleiterschaltelement zum Sperren des Stroms in Entladerichtung in dem zweiten Teil des Leitungszweigs weist eine höhere Spannungsfestigkeit auf als das mindestens eine Halbleiterschaltelement zum Sperren des Ladestroms in dem ersten Teil des Leitungszweigs.

Die Spannungsfestigkeit des mindestens einen Halbleiterschaltelements zum Sperren des Ladestroms liegt bevorzugt zwischen 1 % und 50 %, besonders bevorzugt zwischen 5 % und 25 %, über der maximal möglichen Differenz der von der Spannungsquelle gelieferten Ladespannung und der Spannung des Batteriezellenverbundes.

Die Spannungsfestigkeit des mindestens einen Halbleiterschaltelements zum Sperren des Stroms in Entladerichtung liegt bevorzugt zwischen 1 % und 50 %, besonders bevorzugt zwischen 5 % und 25 %, über der Summe der von der Spannungsquelle gelieferten Ladespannung und der Spannung des Batteriezellenverbundes.

In bevorzugten Ausführungsformen sind in dem beim Aufladen des Batteriezellenverbundes in Durchlassrichtung betriebenen zweiten Teil des Leitungszweigs zwei oder mehr, beispielsweise zwei bis vier, Halbleiterschaltelemente angeordnet. Besonders bevorzugt sind die zwei oder mehr Halbleiterschaltelemente alle identisch ausgebildet.

In besonders bevorzugten Ausführungsformen sind die zwei oder mehr Halbleiterschaltelemente in dem beim Aufladen des Batteriezellenverbundes in Durchlassrichtung betriebenen zweiten Teil des Leitungszweigs alle parallel zueinander geschaltet.

An Stelle der zwei oder mehr Halbleiterschaltelemente kann natürlich aber auch nur ein Halbleiterschaltelement in dem beim Aufladen des Batteriezellenverbundes in Durchlassrichtung betriebenen zweiten Teil des Leitungszweigs angeordnet sein, das dann bevorzugt eine höhere Spannungsfestigkeit als das mindestens eine Halbleiterschaltelement in dem ersten Teil des Leitungszweigs aufweisen sollte.

Bei den Halbleiterschaltelementen in dem elektrischen Leitungszweig handelt es sich besonders bevorzugt um MOSFETs. Alternativ zu diesen können als Halbleiterschaltelemente beispielsweise aber auch Bipolartransistoren, insbesondere Bipolartransistoren mit isolierter Gate-Elektrode (IGBTs) verwendet werden.

In bevorzugten Ausführungsformen zeichnet sich die erfindungsgemäße Batterie durch mindestens eines der folgenden Merkmale aus:
- Das Batteriemanagementsystem umfasst weiterhin eine Überwachungseinrichtung, die Parameter überwacht, die für den korrekten Betrieb und die Sicherheit der Batterie relevant sind.
- Die Überwachungseinrichtung umfasst eine Steuereinheit, die mit der Schalteinrichtung derart gekoppelt ist, dass sie einen Stromfluss zwischen dem Batteriezellenverbund und einer über die Schalteinrichtung mit dem Batteriezellenverbund verbundenen Spannungsquelle beim Laden der Batterie unterbrechen kann.

Besonders bevorzugt ist die Steuereinheit mit den Halbleiterschaltelementen der Schalteinrichtung gekoppelt. Wenn es sich bei diesen um MOSFETs handelt, so sind die Gate-Anschlüsse der MOSFETs mit der Steuereinheit elektrisch verbunden, so dass die Steuereinheit durch Anlegen einer Spannung einen Stromfluss durch die MOSFETs regeln kann.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnung. Hierbei zeigen, jeweils schematisch:
Figur 1 eine Schalteinrichtung nach dem Stand der Technik zur Regelung des Stromflusses zu und/oder von den Batteriezellen einer Batterie;
Figur 2 die Spannungsbelastung der in Figur 1 dargestellten Schalteinrichtung bei einer Verpolung;
Figur 3 die Spannungsbelastung der in Figur 1 dargestellten Schalteinrichtung bei Spannungsbelastung in Laderichtung;
Figur 4 eine Ausführungsform einer elektronischen Schalteinrichtung nach der Erfindung.

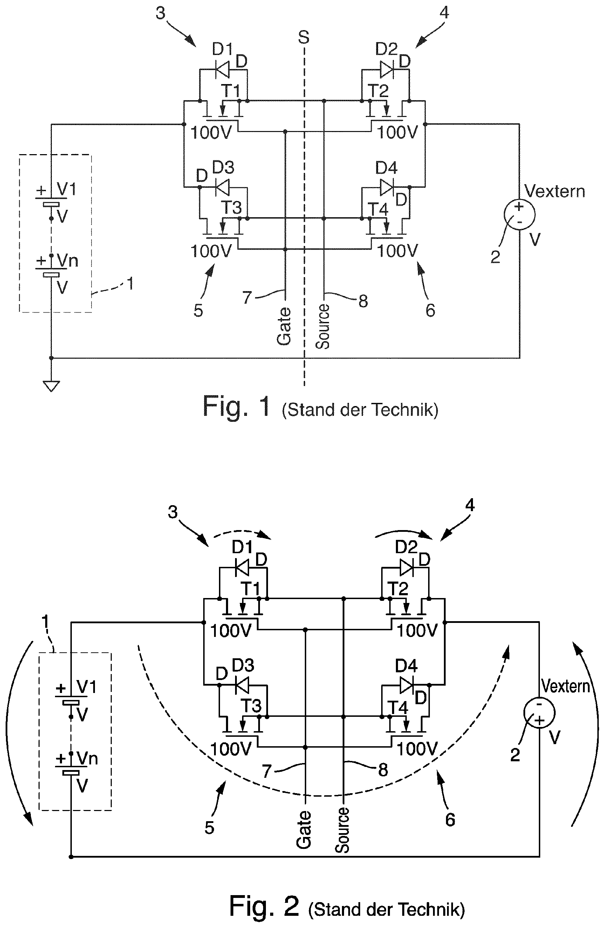

In Figur 1 ist, stark vereinfacht, eine elektronische Schalteinrichtung zwischen einem Batteriezellenverbund 1 aus mehreren Batteriezellen und einer externen Gleichspannungsquelle 2 nach dem Stand der Technik dargestellt. Diese Schalteinrichtung soll sicherstellen, dass nur dann Strom fließt, wenn eine Überwachungseinrichtung den Stromfluss freigibt. Anhand dieses zum Stand der Technik gehörenden Beispiels soll die Problematik und die diese Problematik lösende Erfindung erläutert werden.

Zum Schalten werden Halbleiterschaltelemente verwendet, vorliegend MOSFETs. Diese können in Abhängigkeit von einer Sperrspannung zwischen Gate und Source den Strom sperren oder durchlassen. Aufgrund ihrer internen Eigenschaften können Sie den Strom jedoch nur in einer Richtung sperren. Daher enthält die in Figur 1 dargestellte Anordnung zwischen dem positiven Pol des Batteriezellenverbundes 1 und dem entsprechenden positiven Pol der externen Gleichspannungsquelle 2 einen ersten aus zwei Teilen 3, 4 bestehenden Leitungszweig, in dem jeweils ein Halbleiterschaltelement T1, T2 angeordnet ist. Beide Halbleiterschaltelemente T1, T2 sind umgekehrt, d. h. antiseriell, geschaltet. D1 und D2 bezeichnen intrinsische Dioden (Bodydioden) der Halbleiterschaltelemente T1 und T2. Das in dem Teilzweig 3 angeordnete Halbleiterschaltelement T1 hat eine Durchlassrichtung von rechts nach links, also von der externen Gleichspannungsquelle 2 zu dem Batteriezellenverbund 1. Dementsprechend hat das Halbleiterschaltelement T2 in dem Leitungsteilzweig 4 eine Durchlassrichtung von links nach rechts, also in Richtung von dem Batteriezellenverbund 1 zu der externen Gleichspannungsquelle 2.

Um eine ausreichende Stromtragfähigkeit sicherzustellen, ist zu dem aus den beiden Teilen 3, 4 bestehenden Leitungszweig ein zweiter, ebenfalls aus zwei Teilen 5, 6 bestehender Leitungszweig parallel geschaltet. Er ist genauso aufgebaut wie der aus den Teilen 3, 4 bestehende Leitungszweig. Die Gate-Anschlüsse aller vier Halbleiterschaltelemente sind durch eine zu einer Steuereinheit führende Leitung 7 zusammengefasst, ebenso die Source-Anschlüsse aller vier Halbleiterschaltelemente T1 bis T4 durch eine Leitung 8. Grundsätzlich wäre dies auch anders realisierbar. So wäre es durchaus denkbar, die Halbleiterschaltelemente T1 bis T4 jeweils separat anzusteuern und/oder die Halbleiterschaltelemente an ihren Drain-Anschlüssen D zusammenzuschalten. Die dargestellte Ausführung ist in der Regel aber bevorzugt.

Die Steuereinheit ist Bestandteil einer Überwachungseinrichtung, die mögliche Parameter, die für den Betrieb und die Sicherheit sowohl der Batterie als auch der von ihr abhängigen Komponenten wichtig sind, beispielsweise auch die Temperatur des Batteriezellenverbundes 1, überwacht. Wenn einer der überwachten Parameter aus einem vorgegebenen Rahmen läuft, so kann die Steuereinheit einen Stromfluss zwischen dem Batteriezellenverbund 1 und der Gleichspannungsquelle 2 unterbrechen.

Wie man der Figur 1 entnehmen kann, ist Schalteinrichtung symmetrisch zu der Trennlinie S zwischen den beiden Teilen 3, 4 und 5, 6 ausgebildet. Die vier Halbleiterschaltelemente T1 bis T4 weisen jeweils die gleiche Spannungsfestigkeit auf, sie unterscheiden sich lediglich durch die Richtung und Positionierung innerhalb der Schalteinrichtung.

Anhand der Figur 2 wird nun die Wirkungsweise einer solchen Schalteinrichtung erläutert. Die Figur 2 zeigt einen möglichen Grenzfall, nämlich eine Verpolung der externen Gleichspannungsquelle 2. An den Teilzweigen 3, 5 liegt im Sperrfall, wenn also die Halbleiterschaltelemente T1, T3 sperren sollen, eine außerordentlich hohe Spannung an, da in diesem Fall die Spannung des Batteriezellenverbundes 1 und die Spannung der verpolt angeschlossenen externen Gleichspannungsquelle 2 addiert werden. Dagegen werden die in Durchlassrichtung betriebenen Teilzweige 4, 6 nur mit einer geringen Spannung belastet. Geht man als Beispiel von einer Spannung des Batteriezellenverbundes von 52 V und einer externen Gleichspannungsquelle von 57 V aus, so ergibt sich eine Reihenschaltung mit 109 V, sodass unter Berücksichtigung von 0,5 V Spannung in Durchlassrichtung (über T2, T4) an den Halbleiterschaltelementen T1, T3 eine Spannung von 108,5 V in Sperrrichtung anliegt.

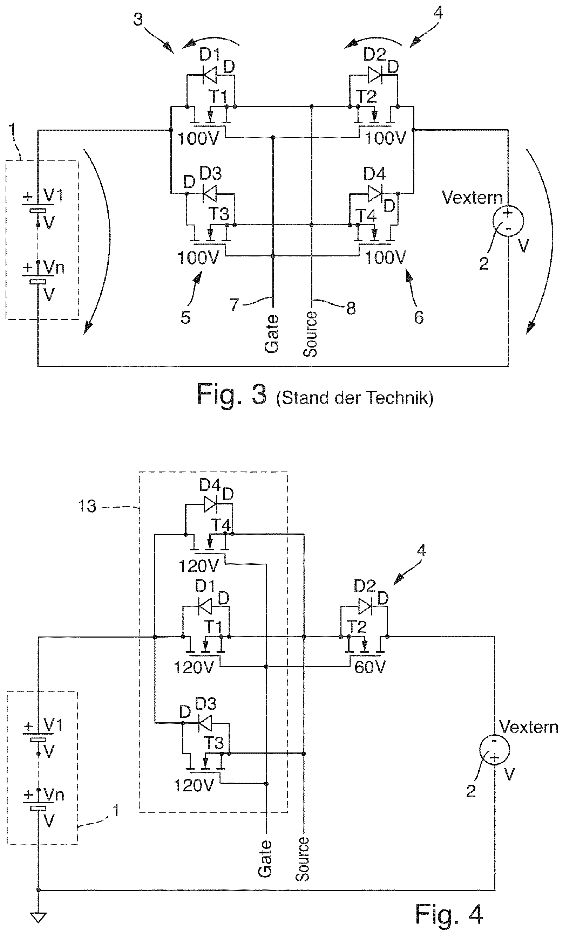

Die Figur 3 zeigt nun den umgekehrten Fall, nämlich den Ladevorgang. In ungünstigsten Fall ist der Batteriezellenverbund 1 vollständig entladen, hat also eine Spannung von 0 V. Die Halbleiterschaltelement T2, T4 in den Teilzweigen 4, 6 dienen in diesem Fall zum Schalten zwischen Durchlass und sperren. Im Sperrfall liegt an ihnen also die Spannung der externen Gleichspannungsquelle 2 an, beispielsweise 56,5 V.

Aus diesen Darlegungen ergibt sich, dass die symmetrische Anordnung von Halbleiterschaltelementen nicht sinnvoll ist, da die Belastung ihrerseits nicht symmetrisch ist. Wird nun die Schalteinrichtung auf die höchste zu erwartende Belastung ausgelegt, was erforderlich ist, so ist die Schalteinrichtung zum Teil überdimensioniert. Dies ergibt Nachteile nicht nur bei den Kosten, sondern auch bei der Effizienz, da spannungsfestere Leistungshalbleiter höhere parasitäre Widerstände und damit Verluste aufweisen.

Die Figur 4 zeigt nun eine Ausführungsform der Erfindung. In dem Teil 4 des Leitungszweigs zwischen der externen Gleichspannungsquelle 2 und dem Batteriezellenverbund 1, der im Ladefall in Sperrrichtung beansprucht wird, ist ein Halbleiterschaltelement T2 mit einer Spannungsfestigkeit angeordnet, die auf die maximale (vergleichsweise niedrige) in diesem Zweig 4 zu erwartende Belastung abgestimmt ist. Die in dem anderen Teil 13 des Leitungszweigs angeordneten Halbleiterschaltelementen T1, T3, T4 sind auf die dort zu erwartende (vergleichsweise höhere) Belastung abgestimmt. Sie weisen eine höhere Spannungsfestigkeit auf.

Wie zu sehen ist, umfasst der beim Aufladen in Durchlassrichtung beaufschlagte Teil 13 des Leitungszweigs in diesem Fall sogar drei parallel geschaltete Halbleiterschaltelemente T1, T3, T4, mit hoher Spannungsfestigkeit während der in Sperrrichtung beaufschlagte Teil 4 des Leitungszweigs nur ein Halbleiterschaltelement T2 mit einer vergleichsweise niedrigen Spannungsfestigkeit aufweist.

Als Halbleiterschaltelemente werden hierbei MOSFETs verwendet.

Zahlenbeispiel:
Spannung der externen Spannungsquelle: 57 V
Batteriespannung des Batteriezellenverbundes: 52 V
Spannungsfestigkeit von T2: 60 V
Spannungsfestigkeit von T1, T3, T4: 120 V

## Patentansprüche

1. Batterie mit
• einem Batteriezellenverbund (1) und
• einem Batteriemanagementsystem,
wobei das Batteriemanagementsystem eine elektronische Schalteinrichtung mit den folgenden Merkmalen aufweist:
a. Sie umfasst einen elektrischen Leitungszweig, in dem mindestens zwei Halbleiterschaltelemente (T1, T2, T3, T4) in umgekehrter Orientierung hintereinander geschaltet sind.
b. Die Halbleiterschaltelemente (T1, T2, T3, T4) sind dazu ausgebildet, einen Stromfluss in dem Leitungszweig jeweils in einer Richtung sperren zu können.
c. Ein Ende des Leitungszweigs ist mit einem Pol des Batteriezellenverbundes (1) verbunden, eine anderes Ende des Leitungszweigs ist dazu eingerichtet, mit einer Spannungsquelle (2) verbunden zu werden.
d. Mindestens eines der Halbleiterschaltelemente (T2) weist innerhalb des Leitungszweigs eine Orientierung auf, die es ihm erlaubt, beim Aufladen des Batteriezellenverbundes (1) einen Ladestrom zu sperren.
e. Das mindestens eine Halbleiterschaltelement (T2) zum Sperren des Ladestroms ist in einem ersten Teil (4) des Leitungszweigs angeordnet.
f. Mindestens eines der Halbleiterschaltelemente (T1, T3, T4) weist innerhalb des Leitungszweigs eine Orientierung auf, die es ihm erlaubt, beim Entladen des Batteriezellenverbundes (1) einen Strom in Entladerichtung zu sperren.
g. Das mindestens eine Halbleiterschaltelement (T1, T3, T4) zum Sperren des Stroms in Entladerichtung ist in einem zweiten Teil (13) des Leitungszweigs angeordnet.
h. Das mindestens eine Halbleiterschaltelement (T2) zum Sperren des Ladestroms ist an die größtmögliche in dem ersten Teil (4) in Laderichtung möglicherweise auftretende Spannungsbelastung angepasst.
i. Das mindestens eine Halbleiterschaltelement (T1, T3, T4) zum Sperren des Stroms in Entladerichtung ist an die größtmögliche in dem weiten Teil (13) in Entladerichtung möglicherweise auftretende Spannungsbelastung angepasst.
**Dadurch gekennzeichnet, dass**:
j. Das mindestens eine Halbleiterschaltelement (T1, T3, T4) zum Sperren des Stroms in Entladerichtung in dem zweiten Teil des Leitungszweigs (13) weist eine höhere Spannungsfestigkeit auf als das mindestens eine Halbleiterschaltelement (T2) zum Sperren des Ladestroms in dem ersten Teil des Leitungszweigs (4).

2. Batterie nach Anspruch 1, **gekennzeichnet durch** mindestens eines der folgenden zusätzlichen Merkmale:
a. Die Anpassung an die in Laderichtung oder Entladerichtung möglicherweise auftretende Spannungsbelastung erfolgt durch Auswahl von Halbleiterschaltelementen (T1, T2, T3, T4) mit geeigneter Spannungsfestigkeit.
b. Die Spannungsfestigkeit des mindestens einen Halbleiterschaltelements (T2) zum Sperren des Ladestroms liegt zwischen 1 % und 50 %, besonders bevorzugt zwischen 5 % und 25%, über der maximal möglichen Differenz der von der Spannungsquelle (2) gelieferten Ladespannung und der Spannung des Batteriezellenverbundes (1).
c. Die Spannungsfestigkeit des mindestens einen Halbleiterschaltelements (T1, T3, T4) zum Sperren des Stroms in Entladerichtung liegt bevorzugt zwischen 1 % und 50 % über der Summe der von der Spannungsquelle (2) gelieferten Ladespannung und der Spannung des Batteriezellenverbundes (1).
d. Die Spannungsfestigkeit des mindestens einen Halbleiterschaltelements (T1, T3, T4) zum Sperren des Stroms in Entladerichtung liegt bevorzugt zwischen 5 % und 25 % über der Summe der von der Spannungsquelle (2) gelieferten Ladespannung und der Spannung des Batteriezellenverbundes (1).

3. Batterie nach Anspruch 1 oder Anspruch 2, **gekennzeichnet durch** mindestens eines der folgenden zusätzlichen Merkmale:
a. In dem beim Aufladen des Batteriezellenverbundes (1) in Durchlassrichtung betriebenen zweiten Teil (13) des Leitungszweigs sind zwei oder mehr Halbleiterschaltelemente (T1, T3, T4) angeordnet.
b. Die zwei oder mehr Halbleiterschaltelemente (T1, T3, T4) sind alle parallel zueinander geschaltet.

4. Batterie nach einem der vorhergehenden Ansprüche, zusätzlich **gekennzeichnet durch** das folgende zusätzliche Merkmal:
a. Bei den Halbleiterschaltelementen (T1, T2, T3, T4) handelt es sich um MOSFETs oder IGBTs.

5. Batterie nach einem der vorhergehenden Ansprüche, zusätzlich **gekennzeichnet durch** mindestens eines der folgenden zusätzlichen Merkmale:
a. Das Batteriemanagementsystem umfasst eine Überwachungseinrichtung, die Parameter überwacht, die für den korrekten Betrieb und die Sicherheit relevant sind.
b. Die Überwachungseinrichtung umfasst eine Steuereinheit, die mit der Schalteinrichtung derart gekoppelt ist, dass sie einen Stromfluss zwischen dem Batteriezellenverbund (1) und der Spannungsquelle (2) unterbrechen kann.

## Claims

1. Battery having
• a battery cell assembly (1) and
• a battery management system,
wherein the battery management system has an electronic switching device having the following features:
a. it comprises an electrical line branch in which at least two semiconductor switching elements (T1, T2, T3, T4) are connected in series in the opposite orientation;
b. the semiconductor switching elements (T1, T2, T3, T4) are designed to be able to block a current flow in the line branch in one direction in each case;
c. one end of the line branch is connected to a pole of the battery cell assembly (1), and another end of the line branch is configured to be connected to a voltage source (2);
d. at least one of the semiconductor switching elements (T2) has, inside the line branch, an orientation which allows it to block a charging current when charging the battery cell assembly (1) ;
e. the at least one semiconductor switching element (T2) for blocking the charging current is arranged in a first part (4) of the line branch;
f. at least one of the semiconductor switching elements (T1, T3, T4) has, inside the line branch, an orientation which allows it to block a current in the discharging direction when discharging the battery cell assembly (1);
g. the at least one semiconductor switching element (T1, T3, T4) for blocking the current in the discharging direction is arranged in a second part (13) of the line branch;
h. the at least one semiconductor switching element (T2) for blocking the charging current is adapted to the largest possible voltage load which possibly occurs in the first part (4) in the charging direction;
i. the at least one semiconductor switching element (T1, T3, T4) for blocking the current in the discharging direction is adapted to the largest possible voltage load which possibly occurs in the second part (13) in the discharging direction;
**characterized in that**:
j. the at least one semiconductor switching element (T1, T3, T4) for blocking the current in the discharging direction in the second part of the line branch (13) has a higher dielectric strength than the at least one semiconductor switching element (T2) for blocking the charging current in the first part of the line branch (4).

2. Battery according to Claim 1, **characterized by** at least one of the following additional features:
a. the adaptation to the voltage load which possibly occurs in the charging direction or discharging direction is carried out by selecting semiconductor switching elements (T1, T2, T3, T4) with a suitable dielectric strength;
b. the dielectric strength of the at least one semiconductor switching element (T2) for blocking the charging current is between 1% and 50%, particularly preferably between 5% and 25%, above the maximum possible difference between the charging voltage provided by the voltage source (2) and the voltage of the battery cell assembly (1);
c. the dielectric strength of the at least one semiconductor switching element (T1, T3, T4) for blocking the current in the discharging direction is preferably between 1% and 50% above the sum of the charging voltage provided by the voltage source (2) and the voltage of the battery cell assembly (1);
d. the dielectric strength of the at least one semiconductor switching element (T1, T3, T4) for blocking the current in the discharging direction is preferably between 5% and 25% above the sum of the charging voltage provided by the voltage source (2) and the voltage of the battery cell assembly (1).

3. Battery according to Claim 1 or Claim 2, **characterized by** at least one of the following additional features:
a. two or more semiconductor switching elements (T1, T3, T4) are arranged in the second part (13) of the line branch that is operated in the forward direction when charging the battery cell assembly (1);
b. the two or more semiconductor switching elements (T1, T3, T4) are all connected in parallel with one another.

4. Battery according to one of the preceding claims, additionally **characterized by** the following additional feature:
a. the semiconductor switching elements (T1, T2, T3, T4) are MOSFETs or IGBTs.

5. Battery according to one of the preceding claims, additionally **characterized by** at least one of the following additional features:
a. the battery management system comprises a monitoring device which monitors parameters which are relevant to the correct operation and safety;
b. the monitoring device comprises a control unit which is coupled to the switching device in such a manner that it can interrupt a current flow between the battery cell assembly (1) and the voltage source (2).

## Revendications

1. Batterie comprenant
• un assemblage d'éléments de batterie (1) et
• un système de gestion de batterie,
dans lequel le système de gestion de batterie comprend un dispositif interrupteur électronique présentant les caractéristiques suivantes :
a. Il comprend une branche de conduction électrique dans laquelle au moins deux éléments de commutation à semi-conducteur (T1, T2, T3, T4) sont connectés en série en orientation inversée.
b. Les éléments de commutation à semi-conducteur (T1, T2, T3, T4) sont conçus pour pouvoir bloquer respectivement un flux de courant passant dans un sens dans la branche de conduction.
c. Une extrémité de la branche de conduction est reliée à un pôle de l'assemblage d'éléments de batterie (1), une autre extrémité de la branche de conduction est conçue pour être reliée à une source de tension (2).
d. Au moins l'un des éléments de commutation à semi-conducteur (T2) présente une orientation, à l'intérieur de la branche de conduction, qui lui permet de bloquer un courant de charge lors de la charge de l'assemblage d'éléments de batterie (1).
e. Ledit au moins un élément de commutation à semi-conducteur (T2) destiné à bloquer le courant de charge est disposé dans une première partie (4) de la branche de conduction.
f. Au moins l'un des éléments de commutation à semi-conducteur (T1, T3, T4) présente une orientation, à l'intérieur de la branche de conduction, qui lui permet de bloquer un courant passant dans le sens de la décharge lors de la décharge de l'assemblage d'éléments de batterie (1).
g. Ledit au moins un élément de commutation à semi-conducteur (T1, T3, T4) destiné à bloquer le courant dans le sens de la décharge est disposé dans une seconde partie (13) de la branche de conduction.
h. Ledit au moins un élément de commutation à semi-conducteur (T2) destiné à bloquer le courant de charge est adapté à la charge de tension la plus élevée possible pouvant se produire dans la première partie (4) dans le sens de la charge.
i. Ledit au moins un élément de commutation à semi-conducteur (T1, T3, T4) destiné à bloquer le courant dans le sens de la décharge est adapté à la charge de tension la plus élevée possible pouvant se produire dans la seconde partie (13) dans le sens de la décharge.
**Caractérisé en ce que** :
j. ledit au moins un élément de commutation à semi-conducteur (T1, T3, T4) destiné à bloquer le courant dans le sens de la décharge dans la seconde partie de la branche de conduction (13) présente une rigidité diélectrique supérieure à celle dudit au moins un élément de commutation à semi-conducteur (T2) destiné à bloquer le courant de charge dans la première partie de la branche de conduction (4).

2. Batterie selon la revendication 1, **caractérisée par** au moins l'une des caractéristiques supplémentaires suivantes :
a. L'adaptation à la charge de tension pouvant se produire dans le sens de la charge ou de la décharge s'effectue par sélection d'éléments de commutation à semi-conducteur (T1, T2, T3, T4) ayant une rigidité diélectrique appropriée.
b. La rigidité diélectrique dudit au moins un élément de commutation à semi-conducteur (T2) destiné à bloquer le courant de charge se situe entre 1 % et 50 %, de préférence entre 5 % et 25 %, au-dessus de la différence maximale possible entre la tension de charge fournie par la source de tension (2) et la tension de l'assemblage d'éléments de batterie (1).
c. La rigidité diélectrique dudit au moins un élément de commutation à semi-conducteur (T1, T3, T4) destiné à bloquer le courant dans le sens de la décharge se situe de préférence entre 1 et 50 % au-dessus de la somme de la tension de charge fournie par la source de tension (2) et de la tension de l'assemblage d'éléments de batterie (1).
d. La rigidité diélectrique dudit au moins un élément de commutation à semi-conducteur (T1, T3, T4) destiné à bloquer le courant dans le sens de la décharge se situe de préférence entre 5 et 25 % au-dessus de la somme de la tension de charge fournie par la source de tension (2) et de la tension de l'assemblage d'éléments de la batterie (1).

3. Batterie selon la revendication 1 ou la revendication 2, **caractérisée par** au moins l'une des caractéristiques supplémentaires suivantes :
a. Deux éléments de commutation à semi-conducteur (T1, T3, T4) ou plus sont disposés dans la seconde partie (13) fonctionnant en sens passant de la branche de conduction lors de la charge de l'assemblage d'éléments de batterie (1).
b. Les deux éléments de commutation à semi-conducteur (T1, T3, T4) ou plus sont tous connectés en parallèle.

4. Batterie selon l'une des revendications précédentes, **caractérisée en outre par** la caractéristique supplémentaire suivante :
a. Les éléments de commutation à semi-conducteur (T1, T2, T3, T4) sont des MOSFET ou des IGBT.

5. Batterie selon l'une des revendications précédentes, **caractérisée en outre par** au moins l'une des caractéristiques supplémentaires suivantes :
a. Le système de gestion de batterie comprend un dispositif de surveillance qui surveille les paramètres pertinents pour le bon fonctionnement et la sécurité.
b. Le dispositif de surveillance comprend une unité de commande qui est couplée au dispositif interrupteur de manière à pouvoir interrompre un flux de courant entre l'assemblage d'éléments de batterie (1) et la source de tension (2).
